# EUROPÄISCHE PATENTSCHRIFT

(11) **EP 0 365 085 B1**
(45) Veröffentlichungstag und Bekanntmachung des Hinweises auf die Patenterteilung: **28.12.1994**
(21) Anmeldenummer: 89202581.8
(22) Anmeldetag: 13.10.1989
(51) Int. Cl.: H03G 3/10, H03G 1/00

(54) **Schaltungsanordnung zum Einstellen der Amplitude eines Signals**
Signal amplitude controlling circuit
Circuit de commande de l'amplitude d'un signal

(30) Priorität: 19.10.1988 DE 3835499
(43) Veröffentlichungstag der Anmeldung: 25.04.1990
(73) Patentinhaber: Philips Patentverwaltung GmbH, 22335 Hamburg (DE); Philips Electronics N.V., 5621 BA Eindhoven (NL)
(72) Erfinder: Ragosch, Ernst Peter, D-2000 Hamburg 61 (DE); Schwarz, Henning, D-2057 Reinbek (DE)
(74) Vertreter: Peters, Carl Heinrich, Dipl.-Ing.

(56) Entgegenhaltungen:
- EP-A- 0 025 977
- FR-A- 2 514 214
- GB-A- 2 008 875
- US-A- 4 682 059
- ELECTRONIC ENGINEERING, Bd. 54, Nr. 662, Feb. 1982, S. 29-30, London, GB; R. Barker et al.: "Novel operation of an operational transconductance amplifier".

## Beschreibung

Die Erfindung bezieht sich auf eine Schaltungsanordnung zum Einstellen der Amplitude eines Signals, mit zwei Transistor-Differenzverstärkern, von denen dem einen über seine Hauptstrompfadzuleitung das Signal und dem anderen ein dem Gleichanteil des Signals entsprechender Speisegleichstrom zuführbar, die Amplitude des Signals durch eine an die über Kreuz gekoppelten Steueranschlüsse der Differenzverstärker angelegte Steuerspannung einstellbar und das in seiner Amplitude eingestellte Signal an zwei miteinander über Kreuz komplementär zu den Steueranschlüssen verbundenen Hauptstrompfadausgängen abnehmbar ist.

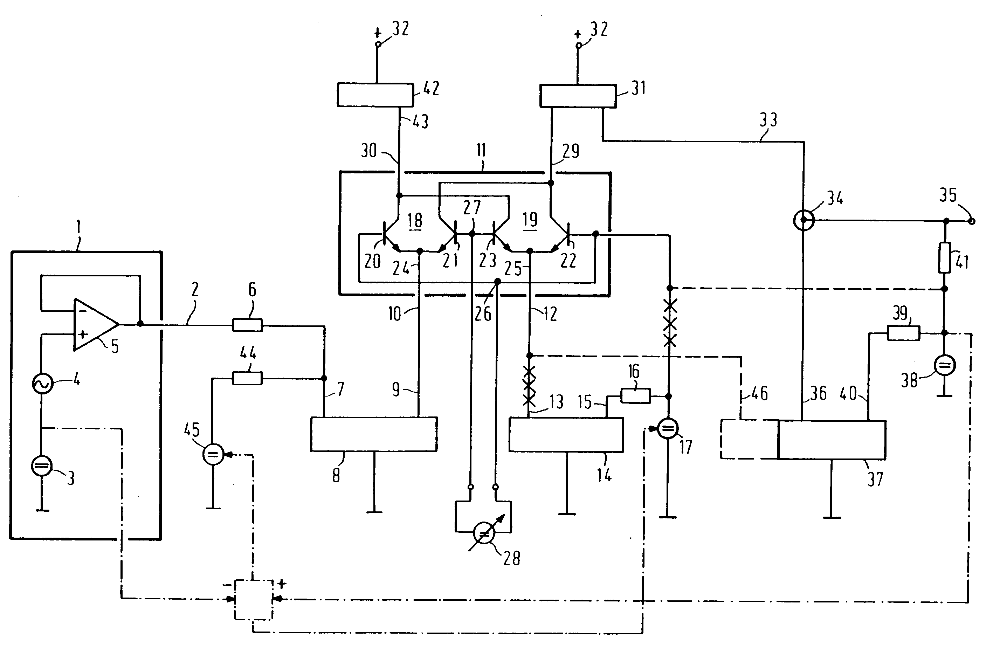

Eine derartige Schaltungsanordnung ist aus der DE-PS 33 31 200, Fig. 2, Stellstufe 6, bekannt. Sie wird dort in einem elektronischen Potentiometer eingesetzt zum Einstellen der Amplitude des Signals in Abhängigkeit von einer Stell- bzw. Steuerspannung. Das Signal wird dabei den miteinander verbundenen Emittern eines Differenzverstärkers als Signaleingang zugeführt, und das in seiner Amplitude eingestellte Signal wird an zwei miteinander über Kreuz gekoppelten Kollektoranschlüssen je eines Transistors der Differenzverstärker abgeführt. Die gekoppelten Kollektoranschlüsse sind über einen Arbeitswiderstand weiterhin mit einem Anschluß einer Spannungsquelle verbunden, die eine gegenüber dem Massepotential positive Versorgungsspannung liefert. Das in seiner Amplitude eingestellte Signal wird somit in Form einer über dem Arbeitswiderstand abfallenden Spannung abgegeben.

Bei der bekannten Schaltungsanordnung sind somit die Spannung des in seiner Amplitude eingestellten Signals, die über den Differenzverstärkern abfallenden Spannungen sowie die Spannung des zugeführten, d.h. in seiner Amplitude einzustellenden Signals zwischen dem positiven Anschluß der Spannungsquelle und Masse angeordnet, d.h. die Versorgungsspannung ist mindestens so groß zu wählen wie die Summe der genannten drei Spannungen.

Des weiteren ist aus GB-A-2 008 875 eine Verstärkeranordnung mit zwei Differentialverstärkerstufen und mittels Spannung einstellbarer Verstärkung bekannt, in welcher Stromspiegel zur Bildung eines Ausgangsignales, welches über einen zweiten Verstärkungsbereich stabil ist, verwendet werden.

Die Erfindung hat die Aufgabe, eine Schaltungsanordnung der eingangs genannten Art für eine Speisung durch kleine Versorgungsspannungen zu schaffen, womit jedoch zugleich hohe Amplituden des einzustellenden bzw. des eingestellten Signals verarbeitet werden können.

Die Aufgabe wird erfindungsgemäß gelöst durch eine Stromsummenschaltung, durch die vom in der Amplitude eingestellten Signal ein dem Speisegleichstrom entsprechender Ausgangsgleichstrom abziehbar ist, und die mit dem Ausang verbunden ist, je eine Stromspiegelanordnung zum Zuführen des Signals, des Speisegleichstroms und des Ausgangsgleichstroms an die Differenzverstärker bzw. die Stromsummenschaltung, und Spannungsquellen, aus denen das Signal, der Speisegleichstrom und der Ausgangsgleichstrom ableitbar sind.

Bei der erfindungsgemäßen Schaltungsanordnung wird in vorteilhafter Weise die Spannungsaussteuerung der bekannten Schaltungsanordnung durch eine Stromaussteuerung ersetzt. Dadurch werden Spannungen in der Schaltungsanordnung weitestgehend vermieden, die zu einer Einengung des Aussteuerungsbereichs der Amplitude des Signals gegenüber der Versorgungsspannung führen. Diese kann daher auf ein Maß reduziert werden, das nur wenig größer ist als die größte Amplitude des Signals. Durch die erfindungsgemäßen Maßnahmen wird jedoch zusätzlich ein sehr konstanter Gleichspannungspegel am Ausgang, d.h. in dem in seiner Amplitude eingestellten Signal, erreicht, da die Stromspeisung der zu einer Multiplizieranordnung verkoppelten Transistor-Differenzverstärker gerade zu einer internen Kompensation der Gleichstromanteile in der Schaltungsanordnung führt. Für eine verzerrungsfreie Aussteuerung mit großen Signalamplituden ist es ferner wichtig, daß das Gleichspannungspotential am Ausgang, d.h. in dem in seiner Amplitude eingestellten Signal, unabhängig von der Signalamplitude konstant bleibt. Dies wird durch die Ableitung der der Multiplizieranordnung zugeführten Ströme aus Spannungsquellen erreicht.

Eine weitere Symmetrisierung der Schaltungsanordnung und damit eine Verbesserung der Konstanz des Gleichspannungspotentials in dem in seiner Amplitude eingestellten Signal wird erreicht durch eine weitere Stromspiegelanordnung zum Übertragen des Signals von den Differenzverstärkern auf die Stromsummenschaltung, und vorzugsweise weiterhin durch eine zusätzliche Stromspiegelanordnung, die mit den beiden übrigen, miteinander verbundenen Hauptstrompfadausgängen gekoppelt ist. Die weitere Stromspiegelanordnung zum Übertragen des Signals ermöglicht dabei insbesondere ein präzises Übertragen des Signals trotz geringer Spannungsdifferenz zwischen den Hauptstrompfadausgängen der Differenzverstärker und dem sie speisenden Anschluß der Versorgungsspannungsquelle, während die zusätzliche Stromspiegelanordnung für eine Symmetrisierung der Spannung auch auf den beiden übrigen Hauptstrompfadausgängen sorgt.

In einer Weiterbildung enthält die erfindungsgemäße Schaltungsanordnung eine Zusatzspannungsquelle, aus der ein Zusatzgleichstrom ableitbar ist, der dem Signal zum Einstellen seines Gleichanteils überlagerbar ist. Vorzugsweise kann dadurch der insgesamt dem Wechselstromanteil des Signals überlagerte Gleichstrom so eingestellt werden, daß er dem Speisegleichstrom und damit dem Ausgangsgleichstrom entspricht. Dadurch wird eine noch bessere Kompensation der Gleichstromanteile in der Schaltungsanordnung erreicht.

Vorzugsweise ist von der Spannungsquelle, aus der der Ausgangsgleichstrom ableitbar ist, weiter eine Ausgangsgleichspannung zum Einstellen des Potentials des in seiner Amplitude eingestellten Signals lieferbar. Durch die doppelte Ausnutzung der Spannungsquelle wird der Schaltungsaufbau vereinfacht und werden Fehlermöglichkeiten durch Fertigungstoleranzen verringert.

Bevorzugt sind ferner der Speisegleichstrom und der Ausgangsgleichstrom aus einer gemeinsamen Spannungsquelle über eine gemeinsame Stromspiegelanordnung ableitbar. Auch diese Maßnahme dient der Einsparung von Bauteilen und dem Eliminieren des Einflusses von Fertigungstoleranzen. Insbesondere wird dafür eine Stromspiegelanordnung mit einem Eingangs- und mehreren Ausgangszweigen eingesetzt. Außerdem kann dabei die Vereinfachung erzielt werden, daß aus der gemeinsamen Spannungsquelle auch eine Gleichvorspannung für die Steuerspannung der Transistor-Differenzverstärker abgeleitet wird.

Die Figur zeigt ein Ausführungsbeispiel, in dem ein in seiner Amplitude einzustellendes Signal am Ausgang 2 einer Signalquelle 1 zur Verfügung steht. Für den inneren Aufbau der Signalquelle 1 ist vereinfachend ein Ersatzschaltbild dargestellt, das eine Gleichspannungsquelle 3 für den Gleichanteil des Signals, eine Wechselspannungsquelle 4 für den Wechselanteil des Signals sowie einen Trennverstärker 5 umfaßt, durch den die Summe der Spannungen von der Gleich- und der Wechselspannungsquelle 3 bzw. 4 am Ausgang 2 niederohmig verfügbar ist. Über einen Vorwiderstand 6 treibt die Signalspannung am Ausgang 2 einen Signalstrom im Eingangszweig 7 eines Signalstromspiegels 8.

Der gegen Masse geschaltete Signalstromspiegel 8 ist mit seinem Ausgangszweig 9 mit einem Signaleingang 10 einer Multiplizieranordnung 11 verbunden und speist darüber den Signalstrom ein. Über einen Speisegleichstromeingang 12 wird der Multiplizieranordnung 11 ferner ein Speisegleichstrom zugeführt, der dem Gleichanteil des Signalstroms, d.h. dem durch die Gleichspannungsquelle 3 hervorgerufenen Stromanteil, am Signaleingang 10 entspricht. Der Speisegleichstrom wird dem Speisegleichstromeingang 12 über den Ausgangszweig 13 eines Speisestromspiegels 14 zugeführt, dessen Eingangszweig 15 zum Ableiten des Speisegleichstroms über einen Widerstand 16 mit einer Spannungsquelle 17 verbunden ist. Auch der Speisestromspiegel 14 ist gegen Masse geschaltet.

Die Multiplizieranordnung 11 besteht aus zwei Transistor-Differenzverstärkern 18 und 19 aus je zwei Transistoren 20, 21 bzw. 22, 23, die mit ihren Hauptstrompfadanschlüssen - im vorliegenden Fall Emitteranschlüsse der bipolar aufgebauten Transistoren - je Differenzverstärker 18 bzw. 19 paarweise verbunden sind. Diese paarweise Verbindung der Emitteranschlüsse der Transistoren 20 und 21 bzw. 22 und 23 bildet eine Hauptstrompfadzuleitung 24 bzw. 25 für den zugehörigen Differenzverstärker. Ferner sind die ersten und die zweiten Transistoren 20, 22 bzw. 21, 23 der beiden Differenzverstärker 18, 19 jeweils über ihre Steueranschlüsse - hier die Basisanschlüsse der bipolaren Transistoren - gekoppelt. Zwischen den Kopplungspunkten 26 bzw. 27 der Steueranschlüsse ist eine Steuerspannungsquelle 28 angeschlossen, die als Steuerspannung eine veränderbare Gleichspannung liefert.

Der erste Transistor 20 bzw. 22 eines der Differenzverstärker 18 bzw. 19 ist mit dem zweiten Transistor 21 bzw. 23 des jeweils anderen Differenzverstärkers 19 bzw. 18 über zweite Hauptstrompfadanschlüsse - hier die Kollektoranschlüsse der bipolaren Transistoren - über Kreuz miteinander verbunden. Diese Verbindung ist also komplementär zu derjenigen der Steueranschlüsse der Transistoren 20 bis 23 ausgeführt; d.h. Steueranschluß und zweiter Hauptstrompfadanschluß jedes der Transistoren 20 bis 23 sind mit unterschiedlichen Transistoren des jeweils anderen Differenzverstärkers 18 bzw. 19 verbunden.

An den zweiten Hauptstrompfadanschlüssen der Transistoren 20 bis 23 treten dem in seiner Amplitude eingestellten Signal entsprechende Ströme auf. Diese daher auch als Hauptstrompfadausgänge bezeichneten Anschlüsse bilden mit ihren beschriebenen Verbindungen Signalausgänge 29 bzw. 30. Vom ersten Signalausgang 29 wird das Signal über eine weitere Stromspiegelanordnung 31, die gegen einen positiven Anschluß 32 einer Spannungsquelle geschaltet ist, und eine Leitung 33 auf eine Stromsummenschaltung 34 übertragen. Diese ist ferner mit einem Ausgang 35 für das in seiner Amplitude eingestellte Signal und einem Ausgangszweig 36 eines gegen Masse geschalteten Ausgangsstromspiegels 37 verbunden. Im Ausgangszweig 36 fließt ein Ausgangsgleichstrom, der aus einer Ausgangsgleichspannungsquelle 38 über einen Widerstand 39 und den Eingangszweig 40 des Ausgangsstromspiegels 37 abgeleitet wird. Die Ausgangsgleichspannungsquelle 38 liefert außerdem über einen weiteren Widerstand 41 eine Gleichvorspannung an den Ausgang 35, die dort als Gleichspannungsanteil des in seiner Amplitude eingestellten Signals auftritt. In der Stromsummenschaltung 34 wird der Ausgangsgleichstrom im Ausgangszweig 36 von dem in seiner Amplitude eingestellten Signal auf der Leitung 33 abgezogen, das hier noch einen Gleichstromanteil enthält. Die Anordnung ist derart dimensioniert, daß der Ausgangsgleichstrom im Ausgangszweig 36 dem Speisegleichstrom am Speisegleichstromeingang 12 der Multiplizieranordnung 11 entspricht, wodurch sich die Gleichstromanteile der Ströme an der Stromsummenschaltung 34 gerade aufheben und nur ein reiner Wechselstromanteil von der Stromsummenschaltung 34 an den Ausgang 35 geliefert wird.

Der zweite Signalausgang 30 der Multiplizieranordnung 11 ist ebenfalls mit dem positiven Anschluß 32 der Spannungsquelle, die die Versorgungsspannung liefert (Versorgungsspannungsquelle) verbunden, und zwar über eine zusätzliche Stromspiegelanordnung 42. Diese weist lediglich einen Eingangszweig 43 auf, und dient zur Erzeugung einer Spannungsdifferenz zwischen dem positiven Anschluß 32 der Spannungsquelle und dem zweiten Signalausgang 30, die mit der Spannungsdifferenz zwischen dem positiven Anschluß 32 und dem ersten Signalausgang 29 übereinstimmt. An der Multiplizieranordnung 11 stellen sich dann symmetrische Potentialverhältnisse ein. Die zusätzliche Stromspiegelanordnung 42 stimmt in ihrem Aufbau mit dem Eingangszweig der weiteren Stromspiegelanordnung 31 überein und besteht im einfachsten Fall aus einer Diode oder einem als Diode geschalteten Transistor.

Der Eingangszweig 7 des Signalstromspiegels 8 ist weiterhin über einen Zusatzwiderstand 44 mit einer Zusatzspannungsquelle 45 verbunden, aus der ein Zusatzgleichstrom ableitbar und über den Zusatzwiderstand 44 in den Eingangszweig 7 des Signalstromspiegels 8 einzuspeisen ist. Dieser Zusatzgleichstrom wird somit dem Signal zum Einstellen seines Gleichanteils, wie er im Ausgangszweig 9 des Signalstromspiegels 8 auftritt und dem Signaleingang 10 der Multiplizieranordnung 11 zugeführt wird, überlagert. Demgemäß werden die Zusatzspannungsquelle 45 und der Zusatzwiderstand 44 derart dimensioniert, daß durch den Zusatzgleichstrom gerade eine Kompensation des Gleichanteils des Stromes im Ausgangszweig 9 mit dem Ausgangsgleichstrom im Ausgangszweig 36 vorliegt, so daß eine optimale Wahl des Arbeitspunktes des Differenzverstärkers 18 erreicht wird. Diese Einstellung der Zusatzspannungsquelle kann fest vorgegeben sein, jedoch ist auch eine Regelung in der durch strichpunktierte Linien angedeuteten Weise möglich, bei der die Zusatzspannungsquelle nach der Differenz der Ausgangsgleichspannung von der Ausgangsgleichspannungsquelle 38 und dem Gleichanteil des Signals von der Gleichspannungsquelle 3 der Signalquelle 1 eingestellt wird. Außerdem ist eine Beeinflussung der Spannungsquelle 17 zur Einstellung und weiteren Optimierung des Arbeitspunktes der Multiplizieranordnung 11 möglich.

In einer Abwandlung des Ausführungsbeispiels gemäß der Figur wird der Speisegleichstrom am Speisegleichstromeingang 12 unmittelbar aus dem Ausgangsstromspiegel 37 abgeleitet, der dazu in der in gestrichelter Weise dargestellten Art erweitert ist. Er weist dann einen weiteren Ausgangszweig 46 auf, der gemeinsam mit dem Ausgangszweig 36 durch den Strom im Eingangszweig 40 gesteuert wird und der unmittelbar mit dem Speisegleichstromeingang 12 verbunden ist. In diesem Fall wird außerdem die Ausgangsgleichspannung von der Ausgangsgleichspannungsquelle 38 unmittelbar dem Kopplungspunkt 26 der Steueranschlüsse der ersten Transistoren 20, 22 zugeführt. Die durchgekreuzten Leitungen sind in diesem Fall aufgetrennt, so daß der Speisestromspiegel 14, der Widerstand 16 und die Spannungsquelle 17 entfallen können. Der Ausgangsstromspiegel 37 stellt dann für den Speisegleichstrom und den Ausgangsgleichstrom eine gemeinsame Stromspiegelanordnung dar, über die diese Ströme aus der als gemeinsame Spannungsquelle wirkenden Ausgangsgleichspannungsquelle 38 abgeleitet werden.

Bei der Schaltungsanordnung nach dem vorliegenden Ausführungsbeispiel sind die Signalquelle 1, die Multiplizieranordnung 11, die Stromsummenschaltung 34 und mit dem Ausgang 35 weiter verbundene nicht dargestellte Anordnungen zur Signalverarbeitung bezüglich des Signalflusses in Kettenschaltung und bezüglich der Versorgungsspannungsquelle parallelgeschaltet. Damit wird der Betrieb bei niedriger Versorgungsspannung möglich. Durch die sehr konstante Ausgangsgleichspannung, auf die das Potential des in seiner Amplitude eingestellten Signals eingestellt ist, können auch Signale großer Amplitude verzerrungsfrei verarbeitet werden.

## Patentansprüche

1. Schaltungsanordnung zum Einstellen der Amplitude eines Signals, mit zwei Transistor-Differenzverstärkern (18, 19), von denen dem einen (18) über seine Hauptstrompfadzuleitung (24) das Signal und dem anderen (19) ein dem Gleichanteil des Signals entsprechender Speisegleichstrom (12) zuführbar, die Amplitude des Signals durch eine an die über Kreuz gekoppelten Steueranschlüsse (26, 27) der Differenzverstärker (18, 19) angelegte Steuerspannung (von 28) einstellbar und das in seiner Amplitude eingestellte Signal an zwei miteinander über Kreuz komplementär zu den Steueranschlüssen verbundenen (an 29) Hauptstrompfadausgängen abnehmbar ist,
gekennzeichnet durch
- eine Stromsummenschaltung (34), durch die vom in der Amplitude eingestellten Signal (auf 33) ein dem Speisegleichstrom entsprechender Ausgangsgleichstrom (auf 36) abziehbar ist, und die mit dem Ausgang (35) verbunden ist,
- je eine Stromspiegelanordnung (8, 14, 37) zum Zuführen des Signals, des Speisegleichstroms und des Ausgangsgleichstroms an die Differenzverstärker (18, 19) bzw. die Stromsummenschaltung (34), und
- Spannungsquellen (1, 17, 38), aus denen das Signal, der Speisegleichstrom und der Ausgangsgleichstrom ableitbar sind.

2. Schaltungsanordnung nach Anspruch 1,
gekennzeichnet durch eine weitere Stromspiegelanordnung (31) zum Übertragen des in seiner Amplitude eingestellten Signals von den Differenzverstärkern (18, 19) auf die Stromsummenschaltung (34).

3. Schaltungsanordnung nach Anspruch 2,
gekennzeichnet durch eine zusätzliche Stromspiegelanordnung (42), die mit den beiden übrigen, miteinander verbundenen Hauptstrompfadausgängen (an 30) gekoppelt ist.

4. Schaltungsanordnung nach Anspruch 1, 2 oder 3,
gekennzeichnet durch eine Zusatzspannungsquelle (45), aus derein Zusatzgleichstrom ableitbar ist, der dem Signal (2) zum Einstellen seines Gleichanteils überlagerbar ist (an 7).

5. Schaltungsanordnung nach Anspruch 1, 2, 3 oder 4,
dadurch gekennzeichnet, daß von der Spannungsquelle (38), aus der der Ausgangsgleichstrom (36) ableitbar ist, weiter eine Ausgangsgleichspannung zum Einstellen des Potentials des in seiner Amplitude eingestellten Signals lieferbar ist (über 41).

6. Schaltungsanordnung nach Anspruch 1, 2, 3, 4 oder 5,
dadurch gekennzeichnet, daß der Speisegleichstrom (an 12, über 46) und der Ausgangsgleichstrom (an 36) aus einer gemeinsamen Spannungsquelle (38) über eine gemeinsame Stromspiegelanordnung (37) ableitbar sind.

## Claims

1. A circuit for controlling the amplitude of the signal, comprising two differential transistor-amplifiers (18, 19), to one (18) of which the signal is applicable via its main current path input (24) and to the other (19) of which a supply direct current corresponding to the d.c. component of the signal is applicable to control the amplitude of the signal by means of a control voltage applied (from 28) to the cross-coupled control connections (26, 27) of the differential amplifiers (18, 19), the amplitude-controlled signal being available at two main current path outputs which are cross-coupled to the control connections (at 29),
characterised by
- a current summing circuit (34) by means of which an output direct current (at 36) corresponding to the supply direct current can be subtracted from the amplitude-controlled signal (at 33), and which is connected to the output (35),
- a current mirror circuit (8, 14, 37) for applying the signal, the supply direct current and the output direct current, respectively, to the differential amplifiers (18, 19) and the current summing circuit (34), respectively, and
- voltage sources (1, 17, 38) from which the signal, the supply direct current and the output direct current are derivable.

2. A circuit as claimed in Claim 1,
characterised by a further current mirror circuit (31) for transferring the amplitude-controlled signal from the differential amplifiers (18, 19) to the current summing circuit (34).

3. A circuit arrangement as claimed in Claim 2,
characterised by an additional current mirror circuit (42) coupled to the interconnected two further main current path outputs (at 30).

4. A circuit arrangement as claimed in Claim 1, 2 or 3,
characterised by an additional voltage source (45) from which an additional direct current is derivable, which additional direct current is superposable on the signal (2) in order to control its d.c. component (at 7).

5. A circuit arrangement as claimed in Claim 1, 2, 3 or 4,
characterised in that an output direct voltage for controlling the potential of the amplitude-controlled signal is available (*via* 41) from the voltage source (38) from which the output direct current (36) is derivable.

6. A circuit arrangement as claimed in Claim 1, 2, 3, 4 or 5,
characterised in that the supply direct current (at 12 *via* 46) and the output direct current (at 36) are derivable from a common voltage source (38) *via* a common current mirror circuit (37).

## Revendications

1. Montage de circuit pour le réglage de l'amplitude d'un signal, comportant deux amplificateurs différentiels transistorisés (18, 19), dont le premier (18) peut recevoir le signal via sa ligne d'amenée du circuit de courant principal (24) et le second (19) peut recevoir un courant continu d'alimentation (12) correspondant à la fraction continue du signal, l'amplitude du signal peut être réglée par une tension de commande (de 28) appliquée aux connexions de commande (26, 27) des amplificateurs différentiels (18, 19) couplées en croix, et le signal d'amplitude réglée peut être prélevé sur deux sorties du circuit d'amenée de courant principal connectées (en 29) l'une à l'autre en croix complémentairement aux connexions de commande, caractérisé par :
- un circuit de sommation de courants (34), qui permet de tirer du signal réglé en amplitude (en 33) un courant continu de sortie (en 36) correspondant au courant continu d'alimentation et qui est connecté à la sortie (35);
- chaque fois un montage de miroir de courant (8, 14, 37) pour acheminer le signal, le courant continu d'alimentation et le courant continu de sortie aux amplificateurs différentiels (18, 19) ou au circuit de sommation de courants (34), et
- des sources de courant (1, 17, 38) d'où l'on peut tirer le signal, le courant continu d'alimentation et le courant continu de sortie.

2. Montage de circuit selon la revendication 1, caractérisé par un autre montage de miroir de courant (31) pour transmettre le signal réglé en amplitude des amplificateurs différentiels (18, 19) au circuit de sommation de courants (34).

3. Montage de circuit suivant la revendication 2, caractérisé par un montage de miroir de courant supplémentaire (42) qui est relié (en 30) aux deux sorties restantes interconnectées de courant principal.

4. Montage de circuit suivant la revendication 1, 2 ou 3, caractérisé par une source de tension additionnelle (45) de laquelle peut être tiré le courant continu additionnel qui peut être superposé (en 7) au signal (2) pour le réglage de sa fraction continue.

5. Montage de circuit suivant la revendication 1, 2, 3 ou 4, caractérisé en ce que la source de tension (38) de laquelle le courant continu de sortie (36) peut être tiré, peut encore délivrer (via 41) une tension continue de sortie pour le réglage du potentiel du signal à amplitude réglée.

6. Montage de circuit suivant la revendication 1, 2, 3, 4 ou 5, caractérisé en ce que le courant continu d'alimentation (en 12, via 46) et le courant continu de sortie (en 36) peuvent être tirés d'une source de tension commune (38) via un montage de miroir de courant commun (37).
